# EUROPÄISCHE PATENTSCHRIFT

(11) **EP 3 204 462 B1**
(45) Veröffentlichungstag und Bekanntmachung des Hinweises auf die Patenterteilung: **24.03.2021**
(21) Anmeldenummer: 15775683.4
(22) Anmeldetag: 06.10.2015
(51) Int. Cl.: C09K 3/10, F16J 15/14

(54) **DICHTMASSE, GEHÄUSE UND ELEKTRONISCHES STEUERGERÄT**
SEALING COMPOUND, HOUSING AND ELECTRONIC CONTROL DEVICE
MATIÈRE D'ÉTANCHÉITÉ, BOÎTIER ET APPAREIL DE COMMANDE ÉLECTRONIQUE

(30) Priorität: 08.10.2014 DE 102014220420
(43) Veröffentlichungstag der Anmeldung: 16.08.2017
(73) Patentinhaber: Vitesco Technologies GmbH, 30165 Hannover (DE)
(72) Erfinder: RIEPL, Thomas, 93077 Bad Abbach (DE); HÄMMERL, Hermann, 84030 Ergolding (DE)
(86) Internationale Anmeldenummer: PCT/EP2015/073024
(87) Internationale Veröffentlichungsnummer: WO 2016/055459

(56) Entgegenhaltungen:
- EP-A1- 1 779 991
- DE-A1- 4 341 598
- DE-A1- 19 851 166
- DE-A1-102005 020 653
- DE-A1-102007 020 227
- DE-A1-102007 060 760
- DE-A1-102011 078 217
- US-A1- 2005 167 431
- US-A1- 2011 073 344
- US-B1- 6 315 300

## Beschreibung

Die vorliegende Offenbarung betrifft eine Dichtmasse, ein Gehäuse für ein elektronisches Steuergerät und ein elektronisches Steuergerät für ein Kraftfahrzeug.

Gehäuse für elektronische Steuergeräte können mehrere Gehäuseteile aufweisen, die - zum Schutz einer in einem Innenraum des Gehäuses angeordneten und mit elektronischen Bauelementen bestückten Leiterplatte - fluiddicht miteinander verbunden sind.

Alterungseffekte können die Dichtigkeit der Verbindung beeinträchtigen, so dass Feuchtigkeit in den Innenraum eindringen und die Leiterplatte und die Bauelemente beschädigen kann.

DE 198 51 166 A1 betrifft aufschäumbare, elektrisch- und wärmeleitfähige Dicht- und Klebstoffe, welche für Dichtungsund Klebzwecke gebräuchliche schäumbare Kunststoffe und Hilfsstoffe, leitfähige Füllstoffe und zum Schäumen geeignete Gase oder gasbildende Stoffe enthalten. Diese können Silikone als Kunststoff, z.B. V, Al oder Pb als leitfähige Zusätze oder weitere Füllstoffe wie z.B. Kieselgel enthalten. Sie können zur Abdichtung von Gehäusen für elektronische Anlagen verwendet werden.

EP 1 779 991 A1 offenbart ein Verfahren zum Abdichten einer Kraftfahrzeugleuchteneinheit, umfassend ein erstes Bauteil mit einer Zungenanordnung und ein zweites Bauteil mit einer Vertiefung, die angepasst ist, um die Zungenanordnung des ersten Bauteils aufzunehmen, wobei das Verfahren die Schritte umfasst:
(i) In-situ-Spritzgießen einer Silikonzusammensetzung oder einer wärmehärtenden Zusammensetzung auf die Zungenanordnung und/oder in die Vertiefung;
(ii) Härten der Silikonzusammensetzung oder der wärmehärtenden Zusammensetzung an Ort und Stelle, um eine Dichtung zu bilden, welche chemisch und/oder physikalisch an diese Zungenanordnung und/oder die Vertiefung gebunden ist; und
(iii) Abdichten der Kraftfahrzeugleuchteneinheit durch mechanisches Eingreifen des ersten Bauteils in das zweite Bauteil, wobei wenigstens eines dieser eine an Ort und Stelle gehärtete Dichtung, welche in Übereinstimung mit den obigen Schritten (i) und (ii) hergestellt wurde, aufweist, dadurch gekennzeichnet, dass die Kraftfahrzeugleuchteneinheit in Schritt (iii) durch Ineinandergreifen des ersten Bauteils und des zweiten Bauteils abgedichtet wird. Die Dichtung kann unter anderem Natriumsilikat oder Aluminiumhydroxid als Füllstoff enthalten.

US 6 315 300 B1 schlägt vor, die Stoßfläche von einem oder von beiden von einem Paar von Substraten mit einer Schicht aus festem Polyurethandichtungsmittel zu versehen, die an mindestens einer der jeweiligen Oberflächen haftet. Die Substrate werden zusätzlich aneinander befestigt, so dass die Stoßflächen das Polyurethandichtungsmittel zwischen sich komprimieren, um eine Fluiddichtung über den gesamten Abstand zwischen den zwei Oberflächen und zwischen dem Polyurethandichtungsmittel und den Passflächen selbst zu bilden. Die Dichtungszusammensetzung kann eine Metallboratkomponente als Korrosionsschutzmittel und ein vernetztes Kopolymer aus einem Isocyanat und einem Polyol enthalten.

In der DE 43 41 598 A1 werden Kompositteilchen offenbart, die als leitende Füllmittel für elektrisch leitende Zusammensetzungen geeignet sind, welche beispielsweise als Dichtmittel, Abdichtungen und Kunststoffe benutzt werden können. Die Zusammensetzungen sind als Materialien für die EMI-Abschirmung und zur Dissipation elektrostatischer Ladungen geeignet.

Es ist daher eine Aufgabe der vorliegenden Offenbarung, eine besonders alterungsstabile Dichtung zu ermöglichen. Es ist eine weitere Aufgabe der vorliegenden Offenbarung, ein Gehäuse für ein elektronisches Steuergerät anzugeben, das besonders langlebig abdichtbar ist.

Diese Aufgaben werden durch eine Dichtmasse und ein Gehäuse mit den Merkmalen der unabhängigen Ansprüche gelöst. Vorteilhafte Ausführungsformen und Weiterbildungen der Dichtmasse, des Gehäuses und ein Steuergerät mit dem Gehäuse sind in den abhängigen Ansprüchen, der folgenden Beschreibung und in den Figuren offenbart.

Gemäß einem Aspekt wird eine Dichtmasse angegeben. Sie ist insbesondere nass aufbringbar. Die Dichtmasse ist zu einer elastischen Dichtung aushärtbar.

Gemäß einem weiteren Aspekt wird ein Gehäuse für ein elektronisches Steuergerät angegeben. Das Gehäuse hat ein erstes, metallisches Gehäuseteil und ein weiteres Gehäuseteil. Das weitere Gehäuseteil kann ebenfalls aus einem metallischen Material gefertigt sein. Beispielsweise handelt es sich bei dem ersten Gehäuseteil um einen Gehäusegrundkörper aus einer Aluminiumlegierung, die insbesondere Silizium und/oder Kupfer enthält. Insbesondere ist das erste Gehäuseteil ein Druckgussbauteil.

Das weitere Gehäuseteil kann ein Gehäusedeckel sein, beispielsweise ein Blech-Deckel. Insbesondere ist das weitere Gehäuseteil aus einem Metallblech - z.B. einem Eisenblech - gefertigt. Bei einer Ausgestaltung ist das weitere Gehäuseteil aus einem zumindest im Bereich der Dichtfuge beschichteten Metallblech gebildet. Beispielsweise ist das Metallblech mit einer Schicht beschichtet, die Zink und/oder Aluminium aufweist oder daraus besteht. Bei einer Weiterbildung enthält die Schicht zusätzlich Magnesium, z.B. eine Zink-Magnesium-Legierung.

Zwischen dem ersten Gehäuseteil und dem weiteren Gehäuseteil ist eine Dichtfuge ausgebildet, die - im fertiggestellten Zustand des Gehäuses - mit einer elastischen Dichtung aus der ausgehärteten Dichtmasse gefüllt ist. Mit anderen Worten ist der von der Dichtfuge gebildete Spalt zwischen den Gehäuseteilen mittels der elastischen Dichtung verschlossen, insbesondere fluiddicht verschlossen.

Gemäß einem weiteren Aspekt wird ein elektronisches Steuergerät für ein Kraftfahrzeug mit dem Gehäuse angegeben.

Darunter, dass die Dichtmasse "nass aufbringbar" ist, wird insbesondere verstanden, dass die Dichtmasse nach dem Aufbringen auf eines der mittels der Dichtmasse abzudichtenden Gehäuseteile plastisch verformbar ist, um bei der Herstellung des Gehäuses die Gestalt der elastischen Dichtung zu erzielen. Insbesondere wird die Dichtmasse beim Andrücken des weiteren Gehäuseteils an das erste Gehäuseteil plastisch verformt, um die Dichtfuge zwischen den beiden Gehäuseteilen fluiddicht zu füllen. Eine nass aufbringbare Dichtmasse wird gelegentlich auch als Dichtungskitt bezeichnet. Die elastische Dichtung wird vom Fachmann auch als FIP-Dichtung ("Formed in Place" Dichtung) oder CIP-Dichtung ("Cured in Place" Dichtung) bezeichnet. Es handelt sich insbesondere nicht um eine vorgeformte Profildichtung und auch nicht um einen Lack.

Die Dichtmasse enthält ein Matrixmaterial. Das Matrixmaterial kann zweckmäßigerweise - jedenfalls in einem nicht ausgehärteten Zustand der Dichtmasse - plastisch verformbar und zu einem elastischen Material aushärtbar sein. Vorzugsweise ist das Matrixmaterial ein Elastomer-Material. Bei dem Matrixmaterial handelt es sich beispielsweise um ein Silikonmaterial, beispielsweise ein Silikonharz, oder um ein Polyurethan-Material, insbesondere um ein PUR-Kunstharz. Auch ein Epoxidharz-Material ist als Matrixmaterial denkbar. Zusätzlich enthält die Dichtmasse einen korrosionshemmenden Zusatzstoff. Mit Vorteil ist aufgrund des korrosionshemmenden Zusatzstoffs in der Dichtmasse die Gefahr besonders gering, dass im Bereich der Dichtfuge zwischen der elastischen Dichtung und dem metallischen Gehäuseteil oder den metallischen Gehäuseteilen Korrosionspfade entstehen, durch welche unerwünschte Stoffe - insbesondere Feuchtigkeit - in einen Innenraum des Gehäuses eindringen können. Insbesondere besteht eine besonders geringe Gefahr, dass die Dichtung an der Grenzfläche zum dem/den metallischen Gehäuseteil(en) durch Korrosion des jeweiligen Gehäuseteils unterwandert wird. Bei konventionellen Gehäusen ist diese Gefahr besonders groß, da die Korrosion in dem vergleichsweise kleinen Spalt zwischen Dichtung und metallischem Gehäuseteil besonders schnell voranschreiten kann.

Eine Nutzung korrosionsarmer Materialien für metallische Gehäuseteile oder eine gezielte Beschichtung der Gehäuseteile vor dem Aufbringen der Dichtmasse ist - vorteilhaft Kosten sparend - bei dem vorliegenden Gehäuse nicht unbedingt erforderlich um eine hohe Korrosionsbeständigkeit der Dichtfuge zu erzielen. Der Querschnitt der Dichtung kann besonders gering gehalten sein.

Der korrosionshemmende Zusatzstoff ist insbesondere in dem Matrixmaterial verteilt. Zweckmäßigerweise kann der korrosionshemmende Zusatzstoff als eine Vielzahl von Partikeln - mit anderen Worten insbesondere als Pulver oder Staub - dem Matrixmaterial zugesetzt sein. Der Median des Äquivalentdurchmessers der Partikel - vom Fachmann auch als d50 oder als mittlere Korngröße bezeichnet - hat beispielsweise einen Wert von 500 µm oder weniger und/oder von 1 µm oder mehr. Vorzugsweise liegt er zwischen 2 µm und 100 µm, zum Beispiel zwischen 5 µm und 60 µm, wobei die Grenzen jeweils eingeschlossen sind. Der Äquivalentdurchmesser ist beispielsweise anhand eines Schliffbilds der ausgehärteten Dichtmasse bestimmbar.

Bei einer Weiterbildung sind die Partikel perlen-förmig, insbesondere kugelförmig und haben vorzugsweise den gleichen Durchmesser. Darunter, dass die perlen-förmigen Partikel den gleichen Durchmesser haben wird vorliegend insbesondere verstanden, dass die Durchmesser von je zwei beliebigen Partikeln um weniger als 10 %, bevorzugt um weniger als 5 % voneinander abweichen. Der Durchmesser der perlen-förmigen Partikel hat bei einer bevorzugten Ausgestaltung einen Wert von 0,1 mm oder mehr und insbesondere von 0,4 mm oder weniger. Beispielsweise hat er einen Wert von etwa 0,3 mm. Auf diese Weise ist mittels der Partikel ein vorteilhafter minimaler Abstand der Gehäuseteile im Bereich der Dichtfuge - d.h. eine minimale Höhe der Dichtfuge - einstellbar. Die Gefahr einer unzureichenden Dichtwirkung oder einer nicht zufriedenstellenden Langzeitstabilität der Dichtung aufgrund einer bereichsweise zu kleinen Höhe der Dichtung ist so besonders gering.

Bevorzugt enthält die Dichtmasse ein Thixotropiermittel, um den korrosionshemmenden Zusatzstoff in der Dichtmasse gleichmäßig zu verteilen. Bei dem Thixotropiermittel kann es sich zum Beispiel um Kieselgel handeln. Auf diese Weise kann der korrosionshemmende Zusatzstoff in einfacher Weise an alle Stellen der Grenzflächen zwischen den Gehäuseteilen und der Dichtmasse gelangen.

Der korrosionshemmende Zusatzstoff ist als Opferanode für eine Korrosionsreaktion mit dem metallischen Gehäuseteil oder den metallischen Gehäuseteilen ausgebildet. Insbesondere enthält die Dichtmasse dazu Partikel eines unedlen Metalls als korrosionshemmenden Zusatzstoff. Mit Vorteil gibt anstelle des jeweiligen Gehäuseteils der korrosionshemmende Zusatzstoff Elektronen ab und wird oxidiert. Dabei kann das Matrixmaterial in durchgehend dichtendem Kontakt mit dem Gehäuseteil bleiben. Die Gefahr einer Oxidation von Gehäusematerial und somit der Bildung eines Spalts zwischen dem Gehäuseteil und dem Matrixmaterial ist besonders gering. Beispielsweise enthält die Dichtmasse Zink-Partikel als korrosionshemmenden Zusatzstoff. Als Opferanode ausgebildete Zusatzstoffe der Dichtmasse können alternativ oder zusätzlich mindestens eines der folgenden Materialien aufweisen oder daraus bestehen: Be, Mg, Ca, ein Lanthanoid wie Sc oder Y oder La, ein Actinoid wie Ac, Ti, Zr, Hf, V, Nb, Ta, Cr, Mn, Zn, Cd, Al, Ga, In, Ti, Pb. Diese Materialien sind beispielsweise bei einem Gehäuseteil, das Eisen aufweist, als Opferanode gut geeignet.

Bei einer weiteren Ausgestaltung ist der korrosionshemmende Zusatzstoff dazu ausgebildet, Zwischenprodukte einer Korrosionsreaktion zu binden. Bei den Zwischenprodukten kann es sich zum Beispiel um Fe³⁺ oder OH⁻ oder FeOOH handeln. Beispielsweise Fe³⁺ kann durch einen anionischen, korrosionshemmenden Zusatzstoff unter Bildung eines schwer löslichen Salzes gebunden werden. Beispielsweise OH⁻ kann durch einen kationischen korrosionshemmenden Zusatzstoff gebunden werden. Bei einer Ausgestaltung enthält die Dichtmasse Zinkphosphat-Partikel als korrosionshemmenden Zusatzstoff.

Weiterhin enthält die Dichtmasse Partikel eines pH-Wert puffernden Materials als korrosionshemmenden Zusatzstoff. Auf diese Weise ist mit Vorteil mindestens ein Gehäuseteil passivierbar - insbesondere, wenn es aus einer Aluminiumlegierung gebildet ist - oder die Reaktionsgeschwindigkeit der Korrosionsreaktion ist besonders gering.

Beispielsweise ist der korrosionshemmende Zusatzstoff durch ein Gemisch von Natriumdihydrogenphosphat mit Dinatriumhydrogenphosphat oder mit Natronlauge gebildet. Es handelt sich bei dem Zusatzstoff dann insbesondere um einen Phosphatpuffer. Insbesondere ist auf diese Weise ein vorgegebener pH-Wert, z.B. im Bereich pH 6-8, erzielbar. Alternativ kann es sich bei dem korrosionshemmenden Zusatzstoff um einen Barbital-Acetat-Puffer nach Michaelis, einen Essigsäure-Acetat-Puffer, einen Kohlensäure-Silicat-Puffer, um 2-(N-Morpholino)ethansulfonsäure, um ein Kohlensäure-Bicarbonat-System, um 4-(2-Hydroxyethyl)-1-piperazinethanesulfonsäure, Tris(hydroxymethyl)-aminomethan, 4-(2-Hydroxyethyl)-piperazin-1-propansulfonsäure, um einen Ammoniakpuffer, um einen Citronensäurepuffer oder einen Citratpuffer handeln.

Bei einer weiteren Ausgestaltung ist das metallische Gehäuseteil zumindest im Bereich der Dichtfuge aus einem ersten metallischen Material gebildet und die Dichtmasse enthält Partikel eines zweiten metallischen Materials als korrosionshemmenden Zusatzstoff, wobei die Elektronegativität des zweiten metallischen Materials größer ist als diejenige des ersten metallischen Materials. Das weitere Gehäuseteil ist bei einer Weiterbildung zumindest im Bereich der Dichtfuge aus dem ersten metallischen Material oder aus einem weiteren metallischen Material gebildet, wobei die Elektronegativität des zweiten metallischen Materials größer ist als diejenige des weiteren metallischen Materials. Mit einem derartigen Zusatzstoff sind - insbesondere mittels einer Austauschreaktion - Atome der metallischen Gehäuseteile ersetzbar, so dass im Bereich der Grenzflächen zwischen Dichtung und dem jeweiligen Gehäuseteil eine Beschichtung hoher Korrosionsbeständigkeit entstehen kann.

Beispielsweise kann der korrosionshemmende Zusatzstoff eine Elektronegativität haben, die größer ist als 1,83. Vorzugsweise ist sie größer als 1,9. In diesen Fällen ist sie größer als die Elektronegativität der vorstehend für das weitere Gehäuseteil bzw. für das erste Gehäuseteil angegebenen Materialien. Zweckmäßig kann die Elektronegativität des korrosionshemmenden Zusatzstoffs kleiner als 2,6 sein. So ist der Zusatzstoff chemisch besonders stabil.

Bevorzugt enthält der korrosionshemmende Zusatzstoff Partikel, die Silber und/oder Nickel aufweisen oder daraus bestehen; beispielsweise Silber-Partikel und/oder Partikel eines Silbersalzes und/oder Nickel-Partikel und/oder Partikel eines Nickelsalzes. Weitere Materialien geeigneter Elektronegativität, von denen der Zusatzstoff eines oder mehrere enthalten oder daraus bestehen kann sind: Mo, W, Ru, Os, Rh, Ir, Pd, Pt, Au, B, Ge, Sn, P, As, Sb, S, Se, Te, Po, At.

Gemäß der beanspruchten Erfindung enthält die Dichtmasse mehrere verschiedene der vorstehend beschriebenen korrosionshemmenden Zusatzstoffe, und zwar einen als Opferanode ausgebildeten Zusatzstoff und ein als ph-Wert Puffer ausgebildetes Material. Durch die verschiedenen Wirkungsweisen kann das Risiko der Bildung von Korrosionspfaden im Bereich der Dichtungsfuge besonders wirkungsvoll verringert sein.

Bei einer Ausgestaltung ist der Volumenanteil des korrosionshemmenden Zusatzstoffs am Volumen der Dichtmasse größer oder gleich 10%. Auf diese Weise ist eine zufriedenstellende Korrosionshemmung erzielbar. Bei einer weiteren Ausgestaltung ist der Volumenanteil kleiner oder gleich 70%, insbesondere kleiner oder gleich 50%. Auf diese Weise ist die Gefahr besonders gering, dass der Zusatzstoff - Leckagepfade erzeugt, welche die elastische Dichtung durchdringen. Ein Volumenanteil von 70% entspricht dabei insbesondere dem Perkolationslimit.

Für die Korrosionshemmung ist es vorteilhaft, wenn die Dichtmasse eine hohe Elektronen- und/oder Ionenmobilität hat. Ist das Matrixmaterial beispielsweise ein Silikonmaterial kann eine zufriedenstellende Ionenmobilität durch die hygroskopischen Eigenschaften des Matrixmaterials erzielt sein. Bei einer anderen Ausgestaltung enthält die Dichtmasse einen Weichmacher, zum Beispiel ein Schwermetall. Auf diese Weise sind ein geringer Vernetzungsgrad der ausgehärteten Dichtmasse und/oder eine niedrige Glastemperatur der Dichtmasse erzielbar, was sich vorteilhaft auf die Elektronen- und/oder Ionenmobilität auswirkt. Alternativ oder zusätzlich kann hierzu die Kettenlänge der Elastomere des Matrixmaterials geeignet gewählt sein.

Weitere Vorteile und vorteilhafte Ausgestaltungen und Weiterbildungen der Dichtmasse, des Gehäuses und des Steuergeräts ergeben sich aus den folgenden, in Zusammenhang mit den Figuren dargestellten Ausführungsbeispielen.

Es zeigen:
- Figur 1: eine schematische Schnittdarstellung eines Ausschnitts eines herkömmlichen Gehäuses,
- Figur 2: eine schematische Schnittdarstellung eines Ausschnitts eines Gehäuses für ein Steuergerät gemäß einem ersten Ausführungsbeispiel,
- Figur 3: eine schematische Schnittdarstellung eines Ausschnitts eines Gehäuses für ein Steuergerät gemäß einem zweiten Ausführungsbeispiel und
- Figur 4: eine schematische Schnittdarstellung eines Ausschnitts eines Gehäuses für ein Steuergerät gemäß einem dritten Ausführungsbeispiel.

Gleiche, gleichartige oder gleich wirkende Elemente sind in den Figuren mit den gleichen Bezugszeichen versehen. In manchen Figuren können einzelne Bezugszeichen zur Verbesserung der Übersichtlichkeit weggelassen sein. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder für eine bessere Verständlichkeit übertrieben groß dargestellt sein.

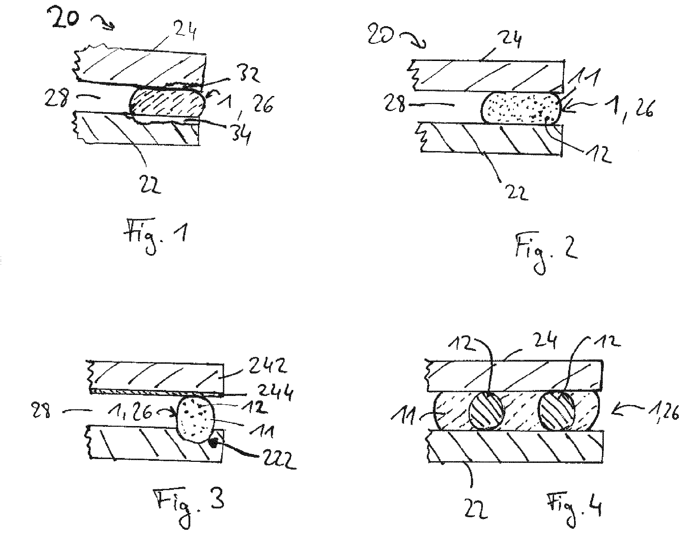

Figur 1 zeigt ein Gehäuse 20 eines elektronischen Steuergeräts mit einer herkömmlichen elastischen Dichtung 1, die in einer Dichtfuge 26 zwischen einem ersten metallischen Gehäuseteil 22 und einem weiteren metallischen Gehäuseteil 24 angeordnet ist. Mittels der entlang der Dichtfuge 26 verlaufenden Dichtung 1 ist ein Innenraum 28 des Gehäuses 20 beispielsweise gegen eindringende Feuchtigkeit abgedichtet.

Im Lauf der Lebensdauer des Steuergeräts können die metallischen Gehäuseteil 22, 24 korrodieren. Dabei können Korrosionspfade 32, 34 entstehen, welche die Dichtung 1 unterwandern. So kann Feuchtigkeit durch die Dichtfuge 26 in den Innenraum 28 des Gehäuses eindringen (siehe z.B. den Korrosionspfad 34 in Figur 1). Die eindringende Feuchtigkeit kann die Funktionsfähigkeit des Steuergeräts beeinträchtigen.

Figur 2 zeigt eine schematische Schnittansicht eines Ausschnitts eines Gehäuses 20 gemäß der Erfindung. Genauer ist in Figur 2 ein Randbereich des Gehäuses 20 gezeigt. Das Gehäuse 20 ist insbesondere ein Gehäuse 20 eines elektronischen Steuergeräts, zum Beispiel eines Steuergeräts eines Kraftfahrzeugs. Beispielsweise ist das Steuergerät ein Motorsteuergerät.

Das Gehäuse 20 hat ein erstes, metallisches Gehäuseteil 22. Bei diesem handelt es sich beispielsweise um ein Druckgussteil aus einer Aluminiumlegierung, insbesondere aus einer dem Fachmann als AlSiCu geläufigen Legierung. Das erste Gehäuseteil ist beispielsweise ein Gehäusegrundkörper, in den eine mit elektronischen Bauteilen bestückte Leiterplatte einsetzbar - und im fertiggestellten Steuergerät eingesetzt - ist.

Das Gehäuse hat ein weiteres Gehäuseteil 24. Beispielsweise ist das weitere Gehäuseteil 24 ein Deckel, der eine Montageöffnung des ersten Gehäuseteils 22 verschließt. Das weitere Gehäuseteil 24 ist vorliegend aus einem Eisenblech geformt, zum Beispiel durch Prägen, Tiefziehen oder dergleichen.

Das weitere Gehäuseteil 24 ist im Bereich der Montageöffnung auf das erste Gehäuseteil 22 derart aufgesetzt, dass entlang eines umfangsseitigen Randbereichs eine Dichtfuge 26 ausgebildet ist, mittels der eine fluiddichte Verbindung zwischen den Gehäuseteilen 22, 24 hergestellt ist.

Die fluiddichte Verbindung ist mittels einer elastischen Dichtung 1 erzielt, welche spaltfüllend in der Dichtfuge 26 angeordnet ist, so dass sie sowohl an das erste Gehäuseteil 22 als auch an das weitere Gehäuseteil 24 angrenzt um die Dichtfuge 26 zu verschließen. Mittels der elastischen Dichtung 1 ist ein Innenraum 28 des Gehäuses 20 fluiddicht gegen die Umgebung des Gehäuses 20 abgeschlossen.

Zur Herstellung der elastischen Dichtung 1 wird eine Dichtmasse nass auf eines der Gehäuseteile 22, 24 aufgebracht - insbesondere in Gestalt einer Dichtraupe - und nachfolgend das andere Gehäuseteil 22, 24 auf die Dichtmasse aufgedrückt. Dabei wird die Dichtmasse plastisch verformt und erhält so ihre endgültige Gestalt. Nachfolgend wird die Dichtmasse zu der elastischen Dichtung 1 ausgehärtet. Hierzu kann die Dichtmasse je nach Material beispielweise mit Licht, z.B. UV-Licht, oder Wärme beaufschlagt werden.

Bei dem vorliegenden Ausführungsbeispiel enthält die Dichtmasse - und damit auch die elastische Dichtung 1 nach dem Aushärten der Dichtmasse - ein Silikonmaterial oder ein Polyurethan-Material als Matrixmaterial 11. Beispielsweise im Fall von Polyurethan-Material kann dem Matrixmaterial 11 ein Schwermetall als Weichmacher zugesetzt sein.

In das Matrixmaterial sind Zink-Partikel mit einem Volumenanteil von 10% oder mehr, beispielsweise von 30% als korrosionshemmender Zusatzstoff 12 eingebettet. Zudem enthält die Dichtmasse vorzugsweise Kieselgel als Thixotropiermittel, um die Zink-Partikel gleichmäßig in dem Silikonmaterial zu verteilen.

Beispielsweise aufgrund von Feuchtigkeit im Bereich der Dichtfuge 26 kann es zu einer Korrosionsreaktion mit den metallischen Gehäuseteilen 22, 24 kommen. Dabei wirken die als korrosionshemmender Zusatzstoff 12 in der Dichtung 1 vorhandenen Zink-Partikel als Opferanode, die Elektronen abgeben und dabei oxidiert werden. Die Elektronenabgabe der Gehäuseteile 22, 24 ist dadurch im Bereich der Dichtfuge 26 mit Vorteil reduziert oder gänzlich verhindert, so dass die Gehäuseteile 22, 24 dort nicht korrodieren. Der Volumenanteil des korrosionshemmenden Zusatzstoffs 12 liegt unterhalb des Perkolationslimits, so dass auch bei dessen Korrosion mittels des Matrixmaterials 11 ein zuverlässig dichtender Kontakt zwischen der Dichtung 1 und den Gehäuseteilen 22, 24 gewährleistet ist. Die Gefahr, dass durch die Dichtfuge 26 Feuchtigkeit in den Innenraum 28 des Gehäuses 20 dringt ist daher besonders gering.

Anstelle der Zink-Partikel oder zusätzlich zu diesen kann die Dichtmasse einen anderen der weiter vorne beschriebenen korrosionshemmenden Zusatzstoffe 12 aufweisen.

Figur 3 zeigt eine schematische Schnittdarstellung eines Randabschnitts eines Gehäuses 20 gemäß einem zweiten Ausführungsbeispiel. Das Gehäuse 20 des zweiten Ausführungsbeispiels entspricht im Wesentlichen demjenigen des ersten Ausführungsbeispiels.

Jedoch hat das weitere Gehäuseteil 24 bei dem vorliegenden Ausführungsbeispiel einen aus einem Eisenblech gebildeten Grundkörper 242. Dieser ist an seiner der Dichtfuge 26 zugewandten Seite mit einer Beschichtung 244 versehen. Die Beschichtung 244 ist vorliegend von einer Zink-Schicht oder einer Zink-Magnesium-Schicht gebildet, die auf den Grundkörper 242 aufgebracht ist. Mittels der Beschichtung 244 ist auch an den von der Dichtung 1 unbedeckten Stellen ein Korrosionsschutz des weiteren Gehäuseteils 24 erzielbar. Der Grundkörper 242 kann alternativ oder zusätzlich an seiner von der Dichtfuge 26 abgewandten Seite mit der Beschichtung 244 versehen sein.

Zudem ist bei dem vorliegenden Ausführungsbeispiel das erste Gehäuseteil 22 mit einer entlang der Dichtfuge 26 verlaufenden Nut 222 versehen. Bei der Herstellung wird die Dichtmasse vorzugsweise als Dichtraupe entlang der Nut 222 auf das erste Gehäuseteil 22 aufgetragen. Dabei ist mittels der Nut 222 die Dichtmasse besonders genau positionierbar.

Figur 4 zeigt eine schematische Schnittdarstellung eines Randabschnitts eines Gehäuses 20 gemäß einem dritten Ausführungsbeispiel. Das Gehäuse 20 des dritten Ausführungsbeispiels entspricht im Wesentlichen demjenigen des ersten Ausführungsbeispiels.

Anstelle von Zinkstaub sind dem Matrixmaterial 11 bei dem vorliegenden Ausführungsbeispiel jedoch kugelförmige Zink-Partikel als korrosionshemmender Zusatzstoff 12 zugesetzt. Alle Partikel haben den gleichen Durchmesser von 0,3 mm.

Mittels der kugelförmigen Zink-Partikel ist die minimale Höhe der Dichtfuge 26 eingestellt. Dazu werden bei der Herstellung die Gehäuseteile 22, 24 - unter plastischer Verformung der auf mindestens eines der Gehäuseteile 22, 24 aufgebrachten Dichtmasse - gegeneinander gepresst bis die Zink-Partikel sowohl das erste Gehäuseteil 22 als auch das zweite Gehäuseteil 24 berühren. Nachfolgend wird die Dichtmasse zu der Dichtung 1 ausgehärtet.

## Patentansprüche

1. Dichtmasse, die nass aufbringbar und zu einer elastischen Dichtung (1) aushärtbar ist, **dadurch gekennzeichnet, dass** die Dichtmasse ein Matrixmaterial (11) und einen korrosionshemmenden Zusatzstoff (12) enthält,
**dadurch gekennzeichnet, dass**
die Dichtmasse mehrere verschiedene korrosionshemmende Zusatzstoffe enthält, wobei die Dichtmasse einen als Opferanode ausgebildeten Zusatzstoff (12) und zudem Partikel eines pH-Wert puffernden Materials als einen weiteren korrosionshemmenden Zusatzstoff (12) enthält.

2. Dichtmasse nach vorhergehendem Anspruch, die ein Silikonmaterial oder ein Polyurethan-Material als Matrixmaterial (11) enthält.

3. Dichtmasse nach einem der vorhergehenden Ansprüche, wobei der korrosionshemmende Zusatzstoff (12) dem Matrixmaterial (11) als eine Vielzahl von Partikeln zugesetzt ist.

4. Dichtmasse nach dem vorhergehendenden Anspruch, wobei die Partikel perlen-förmig sind.

5. Dichtmasse nach dem vorhergehendenden Anspruch, wobei die Partikel den gleichen Durchmesser haben und der Durchmesser einen Wert von 0,1 mm oder mehr und von 0,4 mm oder weniger hat.

6. Dichtmasse nach einem der vorhergehenden Ansprüche, die ein Thixotropiermittel enthält, um den korrosionshemmenden Zusatzstoff (12) in der Dichtmasse gleichmäßig zu verteilen.

7. Dichtmasse nach einem der vorhergehendenden Ansprüche, wobei die Dichtmasse Zink-Partikel als korrosionshemmenden Zusatzstoff (12) enthält.

8. Dichtmasse nach einem der vorhergehendenden Ansprüche, wobei wobei ein korrosionshemmender Zusatzstoff (12) dazu ausgebildet ist, Zwischenprodukte einer Korrosionsreaktion zu binden.

9. Dichtmasse nach einem der vorhergehendenden Ansprüche, wobei die Dichtmasse Zinkphosphat-Partikel als einen der korrosionshemmenden Zusatzstoffe (12) enthält.

10. Gehäuse (20) für ein elektronisches Steuergerät mit einem metallischen Gehäuseteil (22) und einem weiteren Gehäuseteil (24), wobei zwischen dem metallischen Gehäuseteil (22) und dem weiteren Gehäuseteil (24) eine Dichtfuge (26) ausgebildet ist, die mit einer elastischen Dichtung (1) aus der ausgehärteten Dichtmasse nach einem der vorhergehenden Ansprüche gefüllt ist.

11. Gehäuse (20) für ein elektronisches Steuergerät nach dem vorhergehenden Anspruch, wobei das metallische Gehäuseteil (22) zumindest im Bereich der Dichtfuge (26) aus einem ersten metallischen Material gebildet ist und die Dichtmasse Partikel eines zweiten metallischen Materials als korrosionshemmenden Zusatzstoff (12) enthält, wobei die Elektronegativität des zweiten metallischen Materials größer ist als diejenige des ersten metallischen Materials.

12. Gehäuse (20) nach einem der Ansprüche 10 oder 11, wobei das erste metallische Material eine Aluminiumlegierung ist, die Silizium und Kupfer enthält.

13. Gehäuse (20) nach einem der Ansprüche 10 bis 12, wobei das weitere Gehäuseteil (24) aus einem Blech, insbesondere Eisenblech, gebildet ist welches insbesondere beschichtet ist.

14. Gehäuse (20) nach einem der Ansprüche 10 bis 13, wobei der korrosionshemmende Zusatzstoff (12) dem Matrixmaterial (11) als eine Vielzahl von perlen-förmigen Partikeln zugesetzt ist von denen mehrere sowohl das metallische Gehäuseteil (22) als auch das weitere Gehäuseteil (24) berühren um eine minimale Höhe der Dichtfuge (26) einzustellen.

## Claims

1. Sealing compound which can be applied wet and can be cured to give an elastic seal (1), **characterized in that** the sealing compound comprises a matrix material (11) and a corrosion-inhibiting additive (12), **characterized in that** the sealing compound comprises a plurality of different corrosion-inhibiting additives, the sealing compound comprising an additive (12) designed as a sacrificial anode and also particles of a pH-buffering material as a further corrosion-inhibiting additive (12).

2. Sealing compound according to the preceding claim, which comprises a silicone material or a polyurethane material as matrix material (11).

3. Sealing compound according to either of the preceding claims, the corrosion-inhibiting additive (12) having been added to the matrix material (11) in the form of a multiplicity of particles.

4. Sealing compound according to the preceding claim, the particles being bead-shaped.

5. Sealing compound according to the preceding claim, the particles having the same diameter and the diameter having a value of 0.1 mm or more and of 0.4 mm or less.

6. Sealing compound according to any of the preceding claims, which comprises a thixotropic agent for uniform distribution of the corrosion-inhibiting additive (12) in the sealing compound.

7. Sealing compound according to any of the preceding claims, the sealing compound comprising zinc particles as corrosion-inhibiting additive (12).

8. Sealing compound according to any of the preceding claims, a corrosion-inhibiting additive (12) being designed to bind intermediate products of a corrosion reaction.

9. Sealing compound according to any of the preceding claims, the sealing compound comprising zinc phosphate particles as one of the corrosion-inhibiting additives (12).

10. Housing (20) for an electronic control unit, having a metallic housing part (22) and a further housing part (24), there being formed, between the metallic housing part (22) and the further housing part (24), a sealing joint (26) filled with an elastic seal (1) composed of the cured sealing compound according to any of the preceding claims.

11. Housing (20) for an electronic control unit according to the preceding claim, the metallic housing part (22) being formed at least in the region of the sealing joint (26) from a first metallic material, and the sealing compound comprising particles of a second metallic material as corrosion-inhibiting additive (12), the electronegativity of the second metallic material being greater than that of the first metallic material.

12. Housing (20) according to either of Claims 10 and 11, the first metallic material being an aluminium alloy which comprises silicon and copper.

13. Housing (20) according to any of Claims 10 to 12, the further housing part (24) being formed of a metal sheet, more particularly iron sheet, which in particular has been coated.

14. Housing (20) according to any of Claims 10 to 13, the corrosion-inhibiting additive (12) having been added to the matrix material (11) in the form of a multiplicity of bead-shaped particles of which two or more contact both the metallic housing part (22) and the further housing part (24) in order to establish a minimum height of the sealing joint (26).

## Revendications

1. Matière d'étanchéité, qui peut être appliquée mouillée et qui peut durcir en une garniture d'étanchéité (1) élastique, **caractérisée en ce que** la matière d'étanchéité contient un matériau matriciel (11) et un additif (12) inhibiteur de corrosion,
**caractérisée en ce que**
la matière d'étanchéité contient plusieurs additifs inhibiteurs de corrosion différents, la matière d'étanchéité contenant un additif (12) réalisé sous la forme d'une anode sacrificielle et en plus des particules d'un matériau formant tampon d'indice pH en tant qu'un additif (12) inhibiteur de corrosion supplémentaire.

2. Matière d'étanchéité selon la revendication précédente, qui contient un matériau à base de silicone ou un matériau à base de polyuréthane en tant que matériau matriciel (11).

3. Matière d'étanchéité selon l'une des revendications précédentes, l'additif (12) inhibiteur de corrosion étant ajouté au matériau matriciel (11) sous la forme d'une pluralité de particules.

4. Matière d'étanchéité selon la revendication précédente, les particules étant en forme de perles.

5. Matière d'étanchéité selon la revendication précédente, les particules ayant le même diamètre et le diamètre ayant une valeur de 0,1 mm ou plus et de 0,4 mm ou moins.

6. Matière d'étanchéité selon l'une des revendications précédentes, laquelle contient un agent thixotrope afin de distribuer de manière homogène l'additif (12) inhibiteur de corrosion dans la matière d'étanchéité.

7. Matière d'étanchéité selon l'une des revendications précédentes, la matière d'étanchéité contenant des particules de zinc en tant qu'additif (12) inhibiteur de corrosion.

8. Matière d'étanchéité selon l'une des revendications précédentes, un additif (12) inhibiteur de corrosion étant configuré pour lier les produits intermédiaires d'une réaction de corrosion.

9. Matière d'étanchéité selon l'une des revendications précédentes, la matière d'étanchéité contenant des particules de phosphate de zinc en tant que l'un des additifs (12) inhibiteurs de corrosion.

10. Boîtier (20) pour un contrôleur électronique comprenant une partie de boîtier métallique (22) et une partie de boîtier supplémentaire (24), un joint d'étanchéité (26) étant formé entre la partie de boîtier métallique (22) et la partie de boîtier supplémentaire (24), lequel est rempli avec une garniture d'étanchéité (1) élastique composée de la matière d'étanchéité selon l'une des revendications précédentes.

11. Boîtier (20) pour un contrôleur électronique selon la revendication précédente, la partie de boîtier métallique (22) étant formée d'un premier matériau métallique au moins dans la zone du joint d'étanchéité (26) et la matière d'étanchéité contenant des particules d'un deuxième matériau métallique en tant qu'additif (12) inhibiteur de corrosion, la négativité des électrons du deuxième matériau métallique étant supérieure à celle du premier matériau métallique.

12. Boîtier (20) selon l'une des revendications 10 et 11, le premier matériau métallique étant un alliage d'aluminium qui contient du silicium et du cuivre.

13. Boîtier (20) selon l'une des revendications 10 à 12, la partie de boîtier supplémentaire (24) étant formée de tôle, notamment de tôle de fer, qui est notamment revêtue.

14. Boîtier (20) selon l'une des revendications 10 à 13, l'additif (12) inhibiteur de corrosion étant ajouté au matériau matriciel (11) sous la forme d'une pluralité de particules en forme de perles et parmi lesquelles plusieurs entrent en contact à la fois avec la partie de boîtier métallique (22) et la partie de boîtier supplémentaire (24) en vue d'établir une hauteur minimale du joint d'étanchéité (26).
